# EUROPÄISCHE PATENTSCHRIFT

(11) **EP 2 736 081 B1**
(45) Veröffentlichungstag und Bekanntmachung des Hinweises auf die Patenterteilung: **22.06.2016**
(21) Anmeldenummer: 12007888.6
(22) Anmeldetag: 22.11.2012
(51) Int. Cl.: H01L 31/02, H01L 31/042

(54) **Solarzellenmodul**
Solar cell module
Module de cellules solaires

(43) Veröffentlichungstag der Anmeldung: 28.05.2014
(73) Patentinhaber: AZUR SPACE Solar Power GmbH, 74072 Heilbronn (DE)
(72) Erfinder: Löckenhoff, Rüdiger, 74321 Bietigheim-Bissingen (DE)
(74) Vertreter: Koch Müller Patentanwaltsgesellschaft mbH

(56) Entgegenhaltungen:
- EP-A1- 1 705 718
- WO-A1-2010/135801
- DE-A1-102010 028 907

## Beschreibung

Die Erfindung betrifft ein Solarzellenmodul gemäß dem Oberbegriff des Patentanspruchs 1.

Aus der US 6 532 653 B1 ist ein Solarzellenmodul bekannt, bei dem eine Vielzahl von reihenförmig angeordneten Solarzellen in Serie verschaltet sind. Innerhalb einer Reihe sind die einzelnen Solarzellen parallel auf leitfähigen Schichten angeordnet und mit den Schichten elektrisch verschaltet. Um eine Serienverschaltung von einer Reihe zu einer unmittelbar benachbarten Reihe auszubilden, umfasst ein U-förmiger Verbinder sowohl die Oberfläche einer Solarzelle als auch die rückseitige Fläche der gleichen Solarzelle. Auf der rückseitigen Fläche ist zwischen dem Verbinder eine Isolationsschicht ausgebildet, um einen Kurzschluss zwischen Vorderseite und Rückseite des jeweiligen Halbleiterkörper zu vermeiden. Um die einzelnen leitfähigen Schichten voneinander zu isolieren, werden auf der Rückseite der einzelnen Solarzelle zwischen dem U-förmigen Verbinder und der restlichen Rückseite Silikonformstücke ausgebildet.

Aus der US 7 888 592 B2 ist ein Solarzellenmodul bekannt, bei dem ein als Solarzelle ausgebildeter Halbleiterkörper auf einem Träger angeordnet ist. Unterhalb der Solarzelle, d.h. zwischen dem Träger und der Unterseite der Solarzelle ist eine Bypass-Diode auf dem Träger integriert. Des Weiteren sind aus der WO 2010 / 135801 A1 und der DE 10 2010 028 907 A1 weitere Solarzellenmodule mit Anschlusskontaktierungen bekannt.

Aus der US 2003 / 004 720 8 A1 ist ein weiteres Solarzellenmodul bekannt. Hierbei wird auf einem Träger eine Vielzahl von in Reihen angeordneten Halbleiter-Solarzellen ausgebildet, wobei die Rückseiten der Solarzellen einer Reihe mittels eines Lotkissens auf sogenannten Stromschienen parallel verschaltet sind. Die Vorderseite der Solarzellen ist als Empfängerfläche für das Licht ausgebildet und wird mittels eines U-förmigen Verbinders mit der Rückseite der benachbarten Reihe verschaltet.

Mittels der fokussierenden Anordnungen lassen sich mit wenigen kleinen Solarzellen, welche einen Wirkungsgrad bis zu 40% und darüber aufweisen, großflächige Solarmodule aufbauen.

Vor diesem Hintergrund besteht die Aufgabe der Erfindung darin, eine Vorrichtung anzugeben, die den Stand der Technik weiterbildet.

Die Aufgabe wird durch ein Solarzellemodul mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Solarzellemodul mit mindestens einer Solarzelleneinheit bereitgestellt, wobei jede Solarzelleneinheit einen separaten Träger mit einer Vorderseite und einer Rückseite aufweist und der Träger einen ersten elektrischen Anschluss und einen zweiten elektrischen Anschluss umfasst und mit dem ersten Anschluss und dem zweiten Anschluss die von der Solarzelleneinheit erzeugte elektrische Energie abführt, und die Solarzelleneinheit eine Vielzahl von auf der Vorderseite des Trägers in Reihen angeordneten Solarzellen aufweist und die Solarzellen eine als Empfängerfläche für Licht ausgebildete Vorderseite mit einem Vorderseitenkontakt und eine Rückseite mit einem Rückseitenkontakt aufweisen, und die Solarzelleneinheit eine Vielzahl von auf der Vorderseite des Trägers jeweils in Richtung der Reihen der Solarzellen ausgebildete metallische Leiterbahnschienen umfasst und die Leiterbahnschienen jeweils eine Vielzahl von Kontaktflächen einer ersten erster Art aufweisen, und an den Kontaktflächen der ersten Art die Rückseitenkontakte der Solarzellen vorgesehen sind und wobei die Kontaktflächen niederohmig mit den Rückseitenkontakten der Solarzellen verschaltet sind, und die Solarzelleneinheit eine Vielzahl von elektrisch leitfähigen Verbindern aufweist und die Vorderseitenkontakte Rückseitenkontakte der In einer ersten Reihe angeordneten Solarzellen mit den Rückseitenkontakten der in einer zu der ersten Reihe benachbart angeordneten zweiten Reihe von Solarzellen niederohmig verschaltet sind, so dass die erste Reihe und die zweite Reihe eine Serienschaltung ausbilden und auf der Leiterbahnschiene eine zweite Art von Kontaktflächen vorgesehen ist, wobei der Verbinder treppenstufenförmig ausgebildet ist und die in Reihen angeordneten Solarzellen derart auf dem Träger ausgebildet sind, dass die Solarzellen an zwei Seiten des Trägers bis an den Rand des Trägers ausgebildet sind, so dass zwischen Rand des Trägers und den Solarzellen einen Abstand kleiner als 1,0 mm ausgebildet Ist und entlang einer dritten Seite des Trägers die Solarzellen von dem Rand des Trägers beabstandet sind und auf der solarzellenfreien Randfläche an der dritten Seite die Kontaktflächen der zweiten Art ausgebildet sind, wobei der Träger Im Wesentlichen eine viereckige, quaderförmige Form aufweist. Somit weist jede Solarzelleneinheit einen eigenen Träger auf, wobei an mindestens 2 Seiten des Trägers die Solarzellen bis zum Rand belegt sind. Es sei angemerkt, dass die erfindungsgemäßen Solarmodule vorzugsweise in fokussierenden Systemen zur photovoltaischen Stromerzeugung eingesetzt werden. Unter einem fokussierenden System wird vorliegend ein System verstanden, bei dem das Sonnenlicht zuerst konzentriert wird und dann in Form einer Brennfläche auf die Empfangsfläche auftrifft. Hierbei werden Konzentrationsfaktoren vorzugsweise oberhalb von 50, höchst vorzugsweise oberhalb von 100 erreicht. Es versteht sich, dass mittels einer Parallelschaltung von einer Vielzahl von Solarzellen in einer einzelnen Reihe Ströme je Reihe oberhalb einigen Ampere und bei einer Reihenschaltung von einer Vielzahl von Reihen Spannungen in einem Bereich von einigen 10 Volt bis über 100 Volt erzielen lassen.

Ein Vorteil der Anordnung ist es, dass die Vorderseite des Trägers an wenigstens zwei Seiten nahezu randlos mit Solarzellen bedeckt ist und hierdurch eine Nutzung des konzentrierten Sonnenlichts bis zum Rand des Trägers ermöglicht wird. Ungenutztes Sonnenlicht, welches auf den inaktiven Träger fällt, wird in diesen Bereichen weitestgehend vermieden. Untersuchungen haben gezeigt, dass es besonders kostengünstig Ist, auf der Vorderseite des Trägers an einer dritten Seite eine Randfläche auszubilden und In der Randfläche die Anschlusskontakte zweiter Art anzuordnen und hierdurch weitere elektrische Bauelemente anordnen.

In einer Weiterbildung ist es vorteilhaft, wenn mehrere Solarzelleneinheiten zusammengefügt werden, welche jeweils auf eigenen Trägern angeordnet sind, wobei die Seiten bei denen die Solarzellen bis an den Rand des Trägers ausgebildet sind, unmittelbar aneinander anschließen und hierdurch eine nahezu aneinanderliegende Empfangsfläche auszubilden. In einer anderen Ausführungsform Ist jede Reihe der Solarzellen mit einer ESD-Schutzschaltung niederohmig verschaltet, wobei in einer Weiterbildung die Solarzelleneinheit eine Vielzahl von Bypassdioden umfasst und die Bypassdioden mit Kontaktflächen zweiter Art verschaltet sind. In einer anderen Weiterbildung der Solarzelleneinhelten sind die Bypassdioden vollständig auf der Vorderseite des Trägers oder auf einer von dem Träger der Solarzelleneinheit unabhängigen Vorrichtung angeordnet. Gemäß einer alternativen Ausführungsform ist es bevorzugt, dass bei der Solarzelleneinheit wenigstens drei der Kontaktflächen zweiter Art niederohmig mit einer elektrischen Schaltungseinheit verbunden sind, wobei die elektrische Schaltungseinheit keine Solarzellen umfasst. Die Schaltungseinheit ist auf einer externern von dem Träger unabhängigen Vorrichtung angeordnet. In einer bevorzugten Ausführungsform sind bei der Solarzelleneinheit wenigstens ein Teil der Kontaktflächen zweiter Art mit einem DC / DC Wandler niederohmig verschaltet. Vorzugsweise umfasst die elektrische Schaltungseinheit den DC / DC Wandler.

In einer Weiterbildung sind die Solarzellen auf der Vorderseite des Trägers an einer vierten Seite der Solarzelleneinheit derart bis an den Rand ausgebildet sind, dass zwischen Rand des Trägers und den Solarzellen ein Abstand kleiner als 1,0 mm ausgebildet ist. Höchst vorzugsweise beträgt der Abstand weniger als 0,25 mm. Bevorzugt ist weiterhin, dass zwischen dem Rand des Trägers und den Solarzellen an der ersten Seite und / oder an der zweiten Seite ein Abstand kleiner als 0,25 mm ausgebildet ist. Untersuchungen haben gezeigt, dass sich sehr kleine Abstände an der ersten und an der zweiten und an der vierten Seite von etwa 0,15 mm herstellen lassen. Insbesondere bei einer Aneinanderreihung von Solarzelleneinheit, lassen sich hiermit Spaltmaße zwischen zwei unmittelbar benachbarten Solarzelleneinheiten von unterhalb 0,5 mm realisieren. Indem die Spaltmaße verringert werden, fällt weniger Licht auf die Vorderseite des Trägers und der elektrische Wirkungsgrad des Solarmoduls lässt sich erhöhen.

In einer besonders bevorzugten Ausführungsform sind eine Vielzahl von Solarzelleneinheiten dachschindelartig zusammengefügt, wobei die solarzellenfreie Randfläche entlang der dritten Seite der jeweils untenliegenden Solarzelleneinheit, d.h. von denjenigen Solarzelleneinheiten, die teilweise von weiteren Solarzelleneinheiten überdeckt werden, von Solarzellen der darüberliegenden Solarzelleneinheit abgedeckt ist. Es sei angemerkt, dass unter der Bezeichnung "geschindelte Anordnung" oder "dachschindelartig zusammengefügt", eine flächige Überlappung von wenigstens zwei Solarzelleneinheiten verstanden wird.

Es Ist weiterhin bevorzugt, mit mehreren Solarzelleneinheiten eine zusammenhängende Empfangsfläche auszubilden, wobei zwischen zwei unmittelbar benachbarten Solarzelleneinheiten der Ebene der Empfangsflächen ein Spalt kleiner als 2,1 mm, und vorzugsweise kleiner als 1,0 mm ausgebildet ist.

Es sei angemerkt, dass je kleiner der Abstand der Solarzellen zu dem ersten Rand und zu dem zweiten Rand ist, desto geringer Ist auch der Spalt bei einer Aneinanderreihung von Solarzelleneinheiten. Beträgt der Abstand zwischen Solarzelle und Rand ca. 0,15 mm bei der Solarzelleneinheit, ergibt sich ein Spaltmaß zwischen den benachbarten Solarzelleneinheiten von 0,3 mm. Ein Vorteil ist, dass mit der dachschindelförmigen Anordnung sich Anordnungen auch oberhalb von vier in einer Ebene aneinandergereihten Solarzelleneinheiten ausbilden lassen und sich eine beliebig große Empfangsfläche mit sehr geringen Spaltmaßen herstellen lässt. Ein weiterer Vorteil ist, dass die einzelnen Träger nicht eine Größe oberhalb von 40 cm in der Länge und 40 cm in der Breite aufweisen müssen, um große Empfangsflächen auszubilden und sich die Leistung der Module hierdurch im Prinzip beliebig steigern lässt.

In einer anderen Weiterbildung sind vier Solarzelleneinheiten aneinandergefügt, wobei die jeweils dritten Seiten der Solarzelleneinheiten an den äußeren Rändern des derartig zusammengesetzten Solarzellenmoduls angeordnet sind. Insbesondere mit kleinen Randabständen bei den einzelnen Solarzelleneinheiten lässt sich eine größere Empfangsfläche ausbilden, ohne dass der elektrische Wirkungsrad in dem Vergleich zu dem Wirkungsgrad einer einzelnen Solarzelleneinheit um mehr als 10 % sinkt. In einer anderen Ausführungsform sind bei einem Solarzellenmodul, das mehrere Solarzelleneinheiten aufweist, wenigstens die erste Seite und / oder die zweite Seite der Solarzelleneinhelten gleich groß. Indem wenigstens eine Seitenlänge der einzelnen Solarzelleneinheiten gleich ist, lassen sich Empfangsflächen von mehreren Solarzelleneinheiten mit einem hohen elektrischen Wirkungsgrad ausbilden.

Gemäß einer Ausführungsform, ist es vorteilhaft, dass die Solarzellen als Halbleitersolarzellen ausgebildet sind und Insbesondere die Solarzellen jeweils eine Dreifachsolarzelle mit einer Verbindung aus der dritten chemischen Hauptgruppe und einer Verbindung aus der fünften chemischen Hauptgruppe umfasst.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Draufsicht auf eine Solarzelleneinheit eines Solarzellenmoduls,
- Figur 2: eine Draufsicht auf eine zweite Ausführungsform eines Solarzellenmoduls mit vier aneinanderliegenden Solarzelleneinheiten,
- Figur 3a: eine Draufsicht auf eine dritte Ausführungsform eines Solarzellenmoduls mit einer Vielzahl von Solarzelleneinheiten In einer einfach geschindelten Anordnung,
- Figur 3b: eine Querschnittsansicht In Richtung der Schindelrichtung entlang der Linie A - B auf die dritte Ausführungsform dargestellt In der Figur 3a,
- Figur 4: eine Draufsicht auf eine vierte Ausführungsform eines Solarzellenmoduls mit einer Vielzahl von Solarzelleneinheiten In einer zweifach geschindelten Anordnung,
- Figur 4b: eine Querschnittsansicht In Richtung der Schindelrichtung entlang der Linie E -F auf die vierte Ausführungsform dargestellt In der Figur 4a,
- Figur 4c: eine Querschnittsansicht In Richtung der Schindelrichtung entlang der Linie C - D auf die vierte Ausführungsform dargestellt in der Figur 4a,
- Figur 5a: eine Draufsicht auf eine fünfte Ausführungsform eines Solarzellenmoduls mit einer Vielzahl von Solarzelleneinheiten in einer versetzt zweifach geschindelten Anordnung,
- Figur 5b: eine Querschnittsansicht in Richtung der Schindelrichtung entlang der Linie G -H auf die fünfte Ausführungsform dargestellt in der Figur 5a.

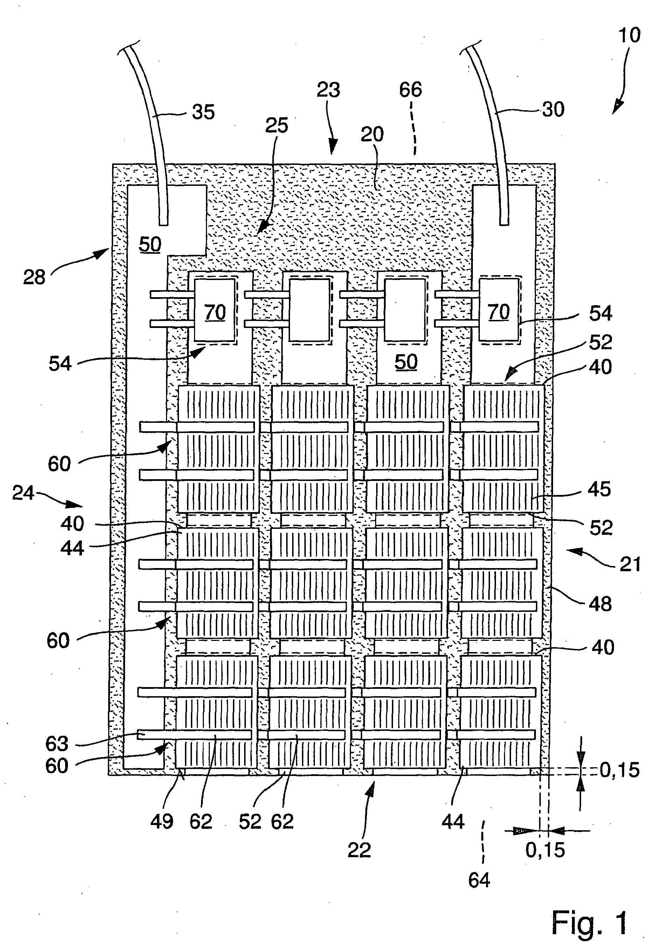

Die Abbildung der Figur 1 zeigt ein Solarzellenmodul, mit einer Solarzelleneinheit 10, wobei die Solarzelleneinheit 10 einen viereckigen, quaderförmigen Träger 20 mit einer Vorderseite 25 und einer Rückseite 28 aufweist und der Träger 20 einen ersten elektrischen Anschluss 30 und einen zweiten elektrischen Anschluss 35 aufweist. Die von der Solarzelleneinheit 10 erzeugte elektrische Energie wird mittels des ersten Anschlusses 30 und mittels des zweiten Anschluss 35 abgeleitet. Auf der Vorderseite 25 des Trägers 20 sind eine Vielzahl von In Reihen angeordneten Solarzellen 40 angeordnet, wobei die Solarzellen 40 eine als Empfängerfläche für Licht ausgebildete Vorderseite 44 mit einem Vorderseitenkontakt 45 und eine Rückseite 48 mit einem Rückseitenkontakt 49 nicht unmittelbar sichtbar aufweisen.

Auf der Vorderseite 25 des Trägers 20 sind die In Reihen angeordneten Solarzellen 20 an einer ersten Seite 21 und an einer zweiten Seite 22 des Trägers 20 bis an den Rand des Trägers 20 ausgebildet. Zwischen dem Rand des Trägers 20 und den Solarzellen 40 ist ein Abstand in der Größe von etwa 0.15 mm ausgebildet. Entlang einer dritten Seite 23 des Trägers 20 sind die Solarzellen 20 von dem Rand des Trägers 20 mehr als 1 mm, vorzugsweise mehr als 2 mm beabstandet. Die derart gebildete Randfläche entlang der dritten Seite 23 weist keine Solarzellen 20 auf. Des Weiteren weist der Träger eine vierte Seite 24 auf. In der dargestellten Ausführungsform sind entlang der vierten Seite 24 keine Solarzellen 40 angeordnet. Es sei jedoch angemerkt, dass es in einer nicht dargestellten alternativen Ausführungsform vorteilhaft ist, die Solarzellen 40 auch an der vierten Seite 24 bis an den Rand des Trägers auszubilden und hierdurch einen Abstand von den Solarzellen bis zu dem Rand von 0,15 mm auszubilden.

Des Weiteren sind auf der Vorderseite 25 des Trägers 20 eine Vielzahl von jeweils in Richtung der Reihen der Solarzellen 40 ausgebildeten metallische Leiterbahnschienen 50 ausgebildet, wobei die Leiterbahnschienen 50 jeweils eine Vielzahl von Kontaktflächen einer ersten erster Art 52 aufweisen. Die Leiterbahnschienen 50 sind als Teil des Trägers 20 ausgeführt und insbesondere mit der Vorderseite 25 des Trägers 20 stoffschlüssig verbunden.

Auf der solarzellenfreien Randfläche an der dritten Seite 23 sind auf den Leiterbahnschienen die Kontaktflächen einer zweiten Art 54 ausgebildet. Auf den Kontaktflächen der ersten Art 52 sind jeweils die Rückseitenkontakte 49 der Solarzellen 40 vorgesehen, wobei die Rückseitenkontakte 49 vorzugsweise mittels eines Lotkissen stoffschlüssig mit den Kontaktflächen der ersten Art 52 verbunden sind und so die Kontaktflächen der ersten Art 52 niederohmig mit den Rückseitenkontakten 49 der Solarzellen 40 elektrisch verschalten.

Ferner Ist eine Vielzahl von elektrisch leitfähigen Verbindern 60 vorgesehen. Die Verbinder 60 weisen einen ersten auf der Oberfläche der Solarzelle 20 angeordneten Schenkel 62 und einen zweiten auf der Unterseite der Solarzelle 20 angeordneten zweiten Schenkel 63 auf. Mit den Verbindern 60 werden die Vorderseltenkontakte 45, der in einer ersten Reihe 64 angeordneten Solarzellen 40, mit den Rückseitenkontakten 49, der In einer zu der ersten Reihe 64 benachbart angeordneten zweiten Reihe 66 von Solarzellen 40, niederohmig verschaltet, so dass die erste Reihe 64 und die zweite Reihe 66 eine Serienschaltung ausbilden und sich die Spannung von den der ersten Reihe 64 mit der Spannung der zweiten Reihe 66 addiert. Des Weiteren sind die einzelnen Reihen bzw. die einzelnen Leiterbahnschienen 50 mittels Bypassdioden 70 verschaltet, wobei jede Bypassdioden 70 mit einer Kontaktfläche der zweiten Art 54 verschaltet ist.

Um eine ebene Empfangsfläche mit den in verschiedenen Reihen angeordneten Solarzellen 20 zu erreichen, sind die Verbinder 60 treppenstufenförmig ausgebildet. Hierbei Ist der zweite Schenkel des Verbinders 60 in dem Lotkissen zwischen dem Rückseitenkontakt 49 und der Kontaktflächen der ersten Art 52 eingebettet. Ferner Ist die unmittelbar In der Nähe der ersten Seite 21 ausgebildete Leiterbahnschiene 50 mit dem ersten elektrischen Anschluss 30 unmittelbar verschaltet und die unmittelbar in der Nähe der vierten Seite 24 ausgebildete Leiterbahnschiene 50 mit einem zweiten elektrischen Anschluss 35 unmittelbar verschaltet. Der erste elektrische Anschluss 30 und der zweite elektrische Anschluss 35 sind mit einer externen elektrischen Schaltungseinheit - nicht dargestellt verbunden, wobei die externe Schaltungseinheit vorzugsweise eine DC / DC Wandlereinheit umfasst.

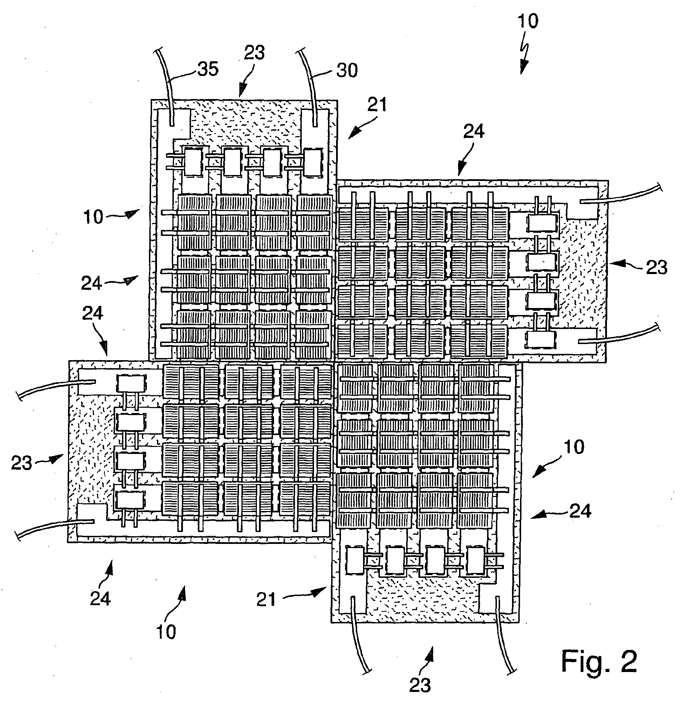

In der Abbildung der Figur 2 Ist eine Draufsicht auf eine zweite Ausführungsform eines Solarzellenmoduls mit vier aneinanderliegenden Solarzelleneinheiteh 10 dargestellt. Aus Gründen der Übersichtlichkeit sind einige der in der Ausführungsform der Figur 1 dargestellten Details nicht abgebildet. Im Folgenden werden nur die Unterschiede zu der Ausführungsform dargestellt in der Figur 1 erläutert. Die vier Solarzelleneinheiten 10 sind in einer ersten Ebene miteinander verbunden, so dass die Empfangsflächen der Solarzellen 40 der vier Solarzelleneinheiten 10 in einer gemeinsamen zweiten Ebene angeordnet sind. Es sei angemerkt, dass die vier Solarzelleneinheiten 10 mit einer gemeinsamen Unterlage - nicht dargestellt- kraftschlüssig verbunden sind und jeweils jede Solarzelleneinheit einen eigenen Träger 20 aufweist. An den äußeren Rändern des Solarzellenmoduls sind die jeweils dritten Seiten 23 und die jeweils vierten Seiten 24 der Solarzelleneinheiten 10 angeordnet. Bezogen auf die Mittelachse der Anordnung, die in Richtung der Normale der Empfangsfläche ausgerichtet ist, sind im Uhrzeigersinn gesehen, die jeweilig erste Seite 21 einer Solarzelleneinheit mit der jeweilig zweiten Seite 22 der unmittelbar anliegenden Solarzelleneinheit aneinandergefügt, wobei das Spaltmaß zwischen zwei benachbarten aneinanderliegenden Solarzelleneinheiten 10 In etwa 0,3 mm beträgt. Hierdurch lässt sich eine auf einfache und kostengünstige Welse eine größere zusammenhängende Empfängerfläche aufbauen.

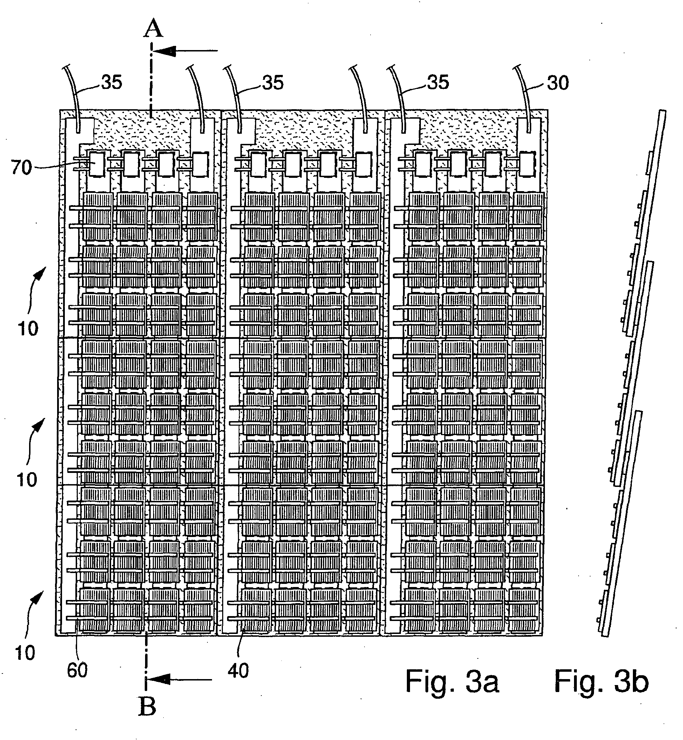

In der Abbildung der Figur 3a ist eine Draufsicht auf eine dritte Ausführungsform eines Solarzellenmoduls mit einer Vielzahl von Solarzelleneinheiten in einer einfach geschindelten Anordnung dargestellt. Aus Gründen der Übersichtlichkeit sind einige, der In der Ausführungsform der Figur 1, dargestellte Details nicht abgebildet. Im Folgenden werden nur die Unterschiede zu der Ausführungsform, dargestellt in der Figur 1, erläutert. In Richtung eine Linie A - B überlappen sich zwei unmittelbar benachbarte Solarzelleneinheiten 10, um die solarzellenfreie Randfläche der jeweilig untenliegenden Solarzelleneinheit 10 mit einer solarzellenbedeckten Fläche der darüberliegenden Solarzelleneinheit 10 abzudecken. Hierbei sind die jeweiligen Normalen auf den jeweiligen Empfangsflächen der einzelnen Solarzelleneinheit 10 parallel zueinander ausgerichtet. Es sei angemerkt, dass In einer nicht dargestellten Ausführungsform, bei der die Solarzellen 40 auch bis zum vierten Rand ausgebildet sind, eine beliebig große, nahezu spaltenfrele Empfangsfläche ausbilden lässt.

In der Darstellung der Figur 3b ist eine Querschnittsansicht entlang der Linie A - B, d.h. In Schindelrichtung, der dritten Ausführungsform in der Figur 3a abgebildet. Es zeigt sich, dass die Empfangsfläche der obenliegenden Solarzelleneinheit 10 die an der dritten Seite 23 der unterliegenden Solarzellenelnheit 10 angeordneten Bypassdioden 70 abdecken. Es versteht sich, dass die einzelnen Solarzelleneinheiten 10 kraftschlüssig mit einer Unterlage verbunden sind, um die eine laterale Bewegung zu unterdrücken. Es zeigt sich, dass in Richtung der Überlappung, also in Schindelrichtung, mittels der Solarzelleneinheiten 10 eine zusammenhängende Empfangsfläche ausgebildet wird. Des Weiteren lassen sich in Schindelrichtung zwischen zwei unmittelbar benachbarten Solarzelleneinheiten sehr kleine Spaltmaße die vorzugsweise bei 0,3 mm liegen, erzielen.

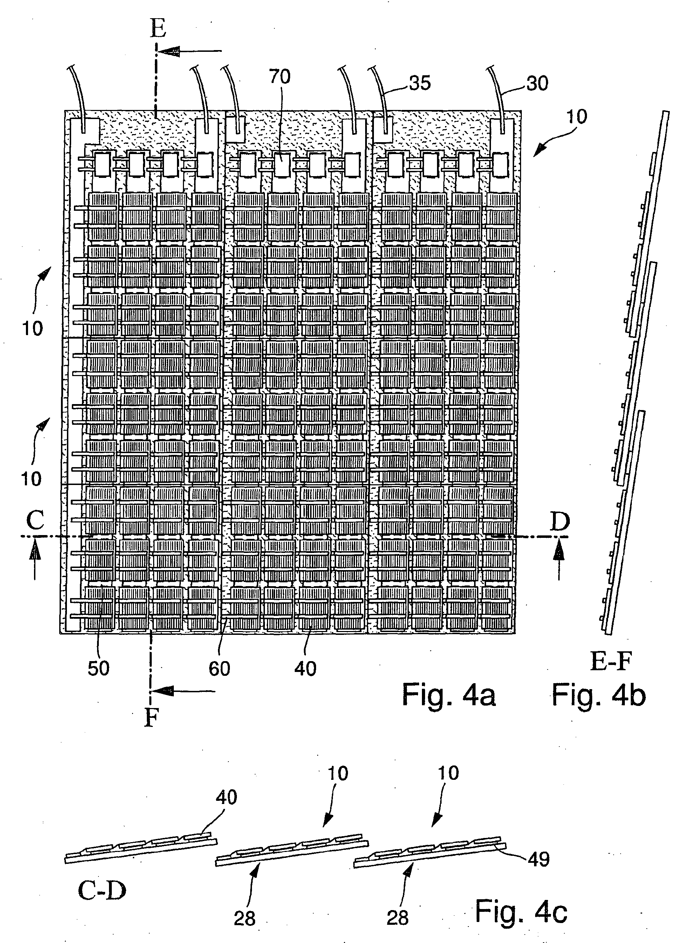

In der Abbildung der Figur 4a Ist eine Draufsicht auf eine vierte Ausführungsform eines Solarzellenmoduls mit einer Vielzahl von Solarzelleneinheiten In einer zweifach geschindelten Anordnung dargestellt. Im Folgenden werden nur die Unterschiede zu den Ausführungsformen, dargestellt In der Figur 3a und der Figur 3b, erläutert. Mit der zweifach geschindelten Anordnung wird vorliegend eine flächige Überlappung von zwei unmittelbar benachbarten Solarzelleneinheiten 10 sowohl entlang einer Linie E - F als auch entlang einer Linie C - D verstanden. Hierbei sind die beiden Linien E - F und C - D orthogonal zu einander angeordnet. Trotz dass eine zweifach geschindelte Anordnung vorliegt, sind die Normalen auf den jeweiligen Solarzelleneinheiten zueinander parallel ausgerichtet. Eine Querschnittsdarstellung der geschindelten Anordnung entlang der Linie E - F findet sich in der Darstellung der Figur 4b und eine Querschnittsdarstellung der geschindelten Anordnung entlang der Linie C - D findet sich in der Darstellung der Figur 4c. Es zeigt sich, dass mit der Überlappung an der dritte Seite 23 in Verbindung mit der Überlappung an der vierten Seite 24, es ausreichend ist, die Solarzellen 40 bei der jeweiligen Solarzelleneinheit 10 nur an der ersten Seite 21 und an der zweiten Seite 22 bis an den Rand anzuordnen und trotzdem eine nahezu spaltenfreie beliebig große Empfangsfläche auszubilden.

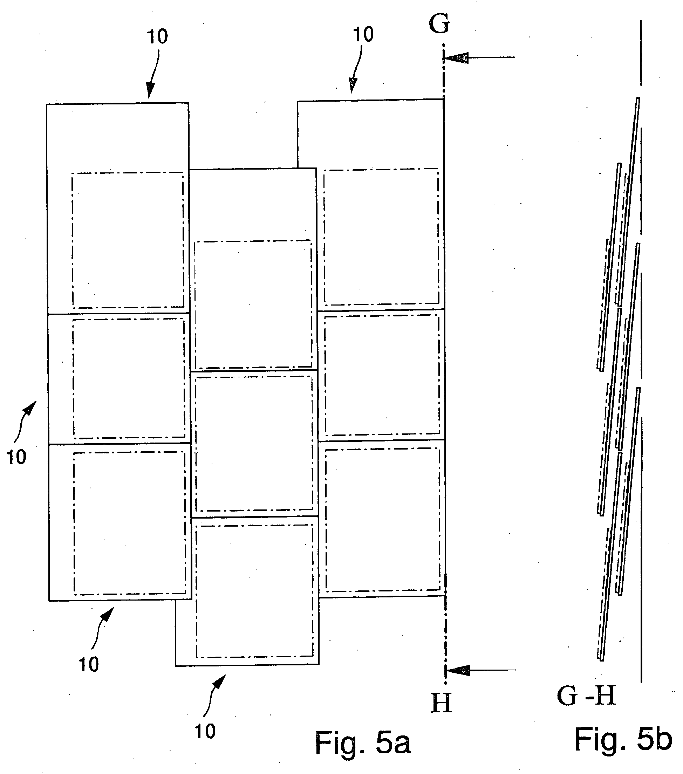

In der Abbildung der Figur 5a Ist eine Draufsicht auf eine fünfte Ausführungsform eines Solarzellenmoduls mit einer Vielzahl von Solarzelleneinheiten 10 in einer versetzt zweifach geschindelten Anordnung dargestellt. Im Folgenden werden nur die Unterschiede zu den Ausführungsformen, dargestellt in den Figuren 4a bis 4 c erläutert. Vorliegend sind die Solarzelleneinhelten 10, die entlang einer Linie G - H in einer Reihe angeordnet sind gegenüber der benachbarten Reihe versetzt, so dass sich in einer Linie orthogonal zu der Linie G - H keine durchlaufende Linie aus Spalten ergeben. In der Abbildung der 5b Ist eine Querschnittsansicht in Richtung der entlang der Linie G - H dargestellt. Hierbei wird deutlich, dass vorliegend eine Überdeckung In zwei Richtungen entsprechend der Darstellung in der Figur 4a erfolgt, wobei In Ergänzung eine Solarzelieneinheit 10 in einer Reihe lateral in Richtung der Linie G - H um etwa die Hälfte der Länge der Solarzelleneinheit 10 gegenüber der Anordnung der Solarzelleneinheit 10 in der unmittelbar benachbarten Reihe versetzt ist. Mit der so versetzen zweifach Schindelung wird eine geringere Verkippung der Solarzelleneinheiten gegenüber der Ausführungsform in Fig. 4a erreicht.

## Patentansprüche

1. Solarzellenmodul, mit mindestens einer Solarzelleneinheit (10), wobei jede Solarzelleneinheit (10) aufweist,
- einen Träger (20) mit einer Vorderseite (25) und einer Rückseite (28), wobei der Träger einen ersten elektrischen Anschluss (30) und einen zweiten elektrischen Anschluss (35) aufweist und wobei mit dem ersten Anschluss (30) und dem zweiten Anschluss (35) die von der Solarzelleneinheit (10) erzeugte elektrische Energie abführt,
- eine Vielzahl von auf der Vorderseite des Trägers (20) in Reihen angeordneten Solarzellen (40), wobei die Solarzellen (40) eine als Empfängerfläche für Licht ausgebildete Vorderseite mit einem Vorderseitenkontakt und eine Rückseite mit einem Rückseitenkontakt aufweisen,
- eine Vielzahl von auf der Vorderseite des Trägers (20) jeweils in Richtung der Reihen der Solarzellen (40) ausgebildete metallische Leiterbahnschienen, wobei die Leiterbahnschienen (50) jeweils eine Vielzahl von Kontaktflächen einer ersten erster Art (52) aufweisen, und an den Kontaktflächen der ersten Art (52) die Rückseitenkontakte (49) der Solarzellen (10) vorgesehen sind und wobei die Kontaktflächen der ersten Art (52) niederohmig mit den Rückseitenkontakten (49) der Solarzellen (40) verschaltet sind,
- eine Vielzahl von elektrisch leitfähigen Verbindern (60), wobei die Vorderseitenkontakte (45) der in einer ersten Reihe (64) angeordneten Solarzellen (40) mit den Rückseitenkontakten (49) der in einer zu der ersten Reihe benachbart angeordneten zweiten Reihe (66) von Solarzellen (40) niederohmig verschaltet sind, so dass die erste Reihe (64) und die zweite Reihe (66) eine Serienschaltung ausbilden,
- eine zweite Art (54) von Kontaktflächen auf der Leiterbahnschiene (50) vorgesehen ist,
- die Verbinder treppenstufenförmig ausgebildet sind und die in Reihen angeordneten Solarzellen (40) derart auf dem Träger ausgebildet sind, dass die Solarzellen (40) an zwei Seiten (21, 22) des Trägers (20) bis an den Rand des Trägers (20) ausgebildet sind, so dass zwischen Rand des Trägers (20) und den Solarzellen (40) einen Abstand kleiner als 1,0 mm ausgebildet ist und entlang einer dritten Seite (23) des Trägers (20) die Solarzellen (40) von dem Rand des Trägers (20) beabstandet sind und auf der solarzellenfreien Randfläche an der dritten Seite (23) die Kontaktflächen der zweiten Art (54) ausgebildet sind, wobei der Träger (20) im Wesentlichen eine viereckige, quaderförmige Form aufweist.

2. Solarzellenmodul nach Anspruch 1, **dadurch gekennzeichnet, dass** mehrere Solarzelleneinheiten (10) zusammengefügt werden, wobei Seiten (21, 22) bei denen die Solarzellen (40) bis an den Rand des Trägers (20) der jeweiligen Solarzelleneinheit ausgebildet sind unmittelbar aneinander anschließen und eine aneinanderliegende Empfangsfläche ausbilden.

3. Solarzellenmodul nach Anspruch 1 oder Anspruch 2, **dadurch gekennzeichnet, dass** jede Reihe der Solarzellen (40) mit einer ESD-Schutzschaltung niederohmig verschaltet ist.

4. Solarzellenmodul nach einem der vorangegangenen Ansprüche, **dadurch gekennzeichnet, dass** die Solarzelleneinheit (10) eine Vielzahl von Bypassdioden (70) umfasst und die Bypassdioden (70) mit Kontaktflächen der zweiten Art (54) verschaltet sind.

5. Solarzellenmodul nach einem der vorangegangenen Ansprüche, **dadurch gekennzeichnet, dass** bei der Solarzelleneinheit (10) wenigstens drei der Kontaktflächen der zweiten Art (54) niederohmig mit einer elektrischen Schaltungseinheit verbunden sind und die elektrische Schaltungseinheit keine Solarzellen (40) umfasst.

6. Solarzellenmodul nach einem der vorangegangenen Ansprüche, **dadurch gekennzeichnet, dass** bei der Solarzelleneinheit (10) wenigstens ein Teil der Kontaktflächen zweiter Art (54) mit einem DC / DC Wandler niederohmig verschaltet sind.

7. Solarzellenmodul nach einem der vorangegangenen Ansprüche, **dadurch gekennzeichnet, dass** die Solarzellen (40) an einer vierten Seite der Solarzelleneinheit (10) derart bis an den Rand ausgebildet sind, dass zwischen Rand des Trägers und den Solarzellen (40) ein Abstand kleiner als 1,0 mm ausgebildet ist.

8. Solarzellenmodul nach einem der Ansprüche 1 bis 7, **dadurch gekennzeichnet, dass** eine Vielzahl von Solarzelleneinheiten (10) dachschindelartig zusammengefügt sind und die solarzellenfreie Randfläche entlang der dritten Seite (23) der untenliegenden Solarzelleneinheit (10) von Solarzellen (40) der darüberliegenden Solarzelleneinheit (10) abgedeckt ist.

9. Solarzellenmodul nach einem der vorangegangenen Ansprüche, **dadurch gekennzeichnet, dass** mehrere Solarzelleneinheiten (10) eine zusammenhängende Empfangsfläche ausbilden und zwischen zwei unmittelbar benachbarten Solarzelleneinheiten (10) in der Ebene der Empfangsfläche ein Spalt kleiner als 2,1 mm ausgebildet ist.

10. Solarzellenmodul nach Anspruch 9, **dadurch gekennzeichnet, dass** der Spalt kleiner als 1,0 mm ausgebildet ist.

11. Solarzellenmodul nach einem der vorangegangenen Ansprüche, **dadurch gekennzeichnet, dass** zwischen dem Rand des Trägers (20) und den Solarzellen (40) an der ersten Seite (21) und / oder an der zweiten Seite (22) ein Abstand kleiner als 0,25 mm ausgebildet ist.

12. Solarzellenmodul nach einem der vorangegangenen Ansprüche, **dadurch gekennzeichnet, dass** vier Solarzelleneinheiten (10) aneinandergefügt sind, wobei die jeweils dritten Seiten (23) der Solarzelleneinheiten (10) an den äußeren Rändern des Solarzellenmoduls angeordnet sind.

13. Solarzellenmodul nach einem der vorangegangenen Ansprüche, **dadurch gekennzeichnet, dass** die Solarzellen (40) als Halbleitersolarzellen ausgebildet sind und die Solarzellen (40) jeweils eine Dreifachsolarzelle mit einer Verbindung aus der dritten chemischen Hauptgruppe und einer Verbindung aus der fünften chemischen Hauptgruppe umfasst.

## Claims

1. Solar cell module with at least one solar cell unit (10), wherein each solar cell unit (10) comprises:
- a support (20) with a front side (25) and a rear side (28), wherein the support has a first electrical connection (30) and a second electrical connection (35) and wherein the electrical energy generated by the solar cell unit (10) is conducted away by the first connection (30) and the second connection (35),
- a plurality of solar cells (40) arranged in rows on the front side of the support (20), wherein the solar cells (40) have a front side, which is constructed as a receiving surface for light, with a front side contact and a rear side with a rear side contact,
- a plurality of metallic strip conductor rails formed on the front side of the support (20) respectively in the direction of the rows of the solar cells (40), wherein the strip conductor rails (50) each have a plurality of contact surfaces of a first form (52), and the rear-side contacts (49) of the solar cells (10) are provided at the contact surfaces of the first form (52), and wherein the contact surfaces of the first form (52) have a low-resistance connection with the rear-side contacts (49) of the solar cells (40),
- a plurality of electrically conductive connectors (60), wherein the front-side contacts (45) of the solar cells (40) arranged in a first row (64) have a low-resistance connection with the rear-side contacts (49) of the second row (66), which is arranged adjacent to the first row, of solar cells (40) so that the first row (64) and the second row (66) form a series circuit,
- a second form (54) of contact surfaces is provided on the strip conductor rail (50),
- the connectors are of staircase-shaped construction and the solar cells (40) arranged in rows are so formed on the support that the solar cells (40) are formed at two sides (21, 22) of the support (20) up to an edge of the support (20) so that a spacing of less than 1.0 millimetre is formed between the edge of the support (20) and the solar cells (40), and the solar cells (40) are spaced from the edge of the support (20) along a third side (23) of the support (20) and the contact surfaces of the second form (54) are formed at the third side (23) on the edge surface free of solar cells, wherein the support (20) has a substantially quadrilateral block-shaped form.

2. Solar cell module according to claim 1, **characterised in that** several solar cell units (10) are joined together, wherein sides (21, 22) at which the solar cells (40) are formed up to the edge of the support (20) of the respective solar cell unit are formed to directly adjoin one another and form an adjoining receiving surface.

3. Solar cell module according to claim 1 or claim 2, **characterised in that** each row of the solar cells (40) has a low-resistance connection with an ESD protective circuit.

4. Solar cell module according to any one of the preceding claims, **characterised in that** the solar cell (10) comprises a plurality of bypass diodes (70) and the bypass diodes (70) are connected with contact surfaces of the second form (54).

5. Solar cell module according to any one of the preceding claims, **characterised in that** in the solar cell unit (10) at least three of the contact surfaces of the second form (54) have low-resistance connection with an electrical circuit unit and the electrical circuit unit does not include any solar cells (40).

6. Solar cell module according to any one of the preceding claims, **characterised in that** in the solar cell unit (10) at least a part of the contact surfaces of the second form (54) have low-resistive connection with a DC/DC converter.

7. Solar cell module according to any one of the preceding claims, **characterised in that** the solar cells (40) are so formed up to the edge at a fourth side of the solar cell unit (10) that a spacing of less than 1.0 millimetres is formed between the edge of the support and the solar cells (40).

8. Solar cell module according to any one of claims 1 to 7, **characterised in that** solar cell units (10) in a plurality are joined together in the manner of shingles and the edge surface, which is free of solar cells, along the third side (23) of the underlying solar cell unit (10) is covered by solar cells (40) of the solar cell unit (10) thereabove.

9. Solar cell module according to any one of the preceding claims, **characterised in that** several solar cell units (10) form a cohesive receiving surface and a gap of less than 2.1 millimetres is formed between two directly adjacent solar cell units (10) in the plane of the receiving surface.

10. Solar cell module according to claim 9, **characterised in that** the gap is formed to be less than 1.0 millimetres.

11. Solar cell module according to any one of the preceding claims, **characterised in that** a spacing of less than 0.25 millimetres is formed between the edge of the support (20) and the solar cells (40) at the first side (21) and/or at the second side (22).

12. Solar cell module according to any one of the preceding claims, **characterised in that** four solar cell units (10) are joined together, wherein the respective third sides (23) of the solar cell units (10) are arranged at the outer edges of the solar cell module.

13. Solar cell module according to any one of the preceding claims, **characterised in that** the solar cells (40) are constructed as semiconductor solar cells and the solar cells (40) each comprise a ternary solar cell with a compound from the third chemical main group and a compound from the fifth chemical main group.

## Revendications

1. Module de cellules solaires, avec au moins une unité de cellules solaires (10), dans lequel chaque unité de cellules solaires (10) présente,
- un support (20) avec un côté antérieur (25) et un côté postérieur (28), dans lequel le support présente un premier raccord électrique (30) et un deuxième raccord électrique (35) et dans lequel l'énergie électrique produite par l'unité de cellules solaires (10) est évacuée avec le premier raccord électrique (30) et le deuxième raccord électrique (35),
- une multiplicité de cellules solaires (40) disposées en rangées sur le côté antérieur du support (20), dans lequel les cellules solaires (40) présentent un côté antérieur avec un contact de côté antérieur, réalisé sous forme de face de réception pour la lumière, et un côté postérieur avec un contact de côté postérieur,
- une multiplicité de barres conductrices métalliques formées sur le côté antérieur du support (20) respectivement dans la direction des rangées des cellules solaires (40), dans lequel les barres conductrices (50) présentent respectivement une multiplicité de faces de contact d'un premier type (52) et les contacts de côté postérieur (49) des cellules solaires (10) sont prévus sur les faces de contact du premier type (52) et dans lequel les faces de contact du premier type (52) sont connectées avec une faible résistance ohmique aux contacts de côté postérieur (49) des cellules solaires (40),
- une multiplicité de connecteurs électriquement conducteurs (60), dans lequel les contacts de côté antérieur (45) des cellules solaires (40) disposées dans une première rangée (64) sont connectés avec une faible résistance ohmique aux contacts de côté postérieur (49) de la deuxième rangée (66) de cellules solaires (40) disposée à proximité de la première rangée, de telle manière que la première rangée (64) et la deuxième rangée (66) forment une connexion,
- il est prévu un deuxième type (54) de faces de contact sur la barre conductrice (50),
- les connecteurs sont réalisés en forme de marches d'escalier et les cellules solaires (40) disposées en rangées sont formées sur le support, de telle manière que les cellules solaires (40) soient formées sur deux côtés (21, 22) du support (20) jusqu'au bord du support (20), de telle manière qu'une distance inférieure à 1,0 mm soit formée entre le bord du support (20) et les cellules solaires (40) et que les cellules solaires (40) soient espacées du bord du support (20) le long d'un troisième côté (23) du support (20) et que les faces de contact du deuxième type (54) soient formées sur la face de bord sans cellules solaires sur le troisième côté (23), dans lequel le support (20) présente essentiellement une forme quadrilatérale parallélépipédique.

2. Module de cellules solaires selon la revendication 1, **caractérisé en ce que** plusieurs unités de cellules solaires (10) sont réunies, dans lequel des côtés (21, 22) sur lesquels les cellules solaires (40) sont formées jusqu'au bord du support (20) de l'unité de cellules solaires respective se raccordent directement l'un à l'autre et forment une face de réception ininterrompue.

3. Module de cellules solaires selon la revendication 1 ou la revendication 2, **caractérisé en ce que** chaque rangée des cellules solaires (40) est connectée avec une faible résistance ohmique à un circuit de protection ESD.

4. Module de cellules solaires selon l'une quelconque des revendications précédentes, **caractérisé en ce que** l'unité de cellules solaires (10) comprend une multiplicité de diodes de dérivation (70) et les diodes de dérivation (70) sont connectées à des faces de contact du deuxième type (54).

5. Module de cellules solaires selon l'une quelconque des revendications précédentes, **caractérisé en ce que**, dans l'unité de cellules solaires (10), au moins trois des faces de contact du deuxième type (54) sont connectées avec une faible résistance ohmique à une unité de circuit électrique et l'unité de circuit électrique ne comprend aucune cellule solaire (40).

6. Module de cellules solaires selon l'une quelconque des revendications précédentes, **caractérisé en ce que**, dans l'unité de cellules solaires (10), au moins une partie des faces de contact du deuxième type (54) sont connectées avec une faible résistance ohmique à un convertisseur DC/DC.

7. Module de cellules solaires selon l'une quelconque des revendications précédentes, **caractérisé en ce que** les cellules solaires (40) sont formées sur un quatrième côté de l'unité de cellules solaires (10) jusqu'au bord, de telle manière qu'une distance inférieure à 1,0 mm soit formée entre le bord du support et les cellules solaires (40).

8. Module de cellules solaires selon l'une quelconque des revendications 1 à 7, **caractérisé en ce qu'**une multiplicité d'unités de cellules solaires (10) sont réunies à la manière de bardeaux et la face de bord sans cellules solaires le long du troisième côté (23) de l'unité de cellules solaires sous-jacente (10) est recouverte par des cellules solaires (10) de l'unité de cellules solaires susjacente (10).

9. Module de cellules solaires selon l'une quelconque des revendications précédentes, **caractérisé en ce que** plusieurs unités de cellules solaires (10) forment une face de réception ininterrompue et une fente inférieure à 2,1 mm est formée dans le plan de la face de réception entre deux unités de cellules solaires (10) directement voisines.

10. Module de cellules solaires selon la revendication 9, **caractérisé en ce que** la fente formée est inférieure à 1,0 mm.

11. Module de cellules solaires selon l'une quelconque des revendications précédentes, **caractérisé en ce qu'**une distance inférieure à 0,25 mm est formée entre le bord du support (20) et les cellules solaires (40) sur le premier côté (21) et/ou sur le deuxième côté (22).

12. Module de cellules solaires selon l'une quelconque des revendications précédentes, **caractérisé en ce que** quatre unités de cellules solaires (10) sont jointes l'une à l'autre, dans lequel les respectivement troisièmes côtés (23) des unités de cellules solaires (10) sont disposés sur les bords extérieurs du module de cellules solaires.

13. Module de cellules solaires selon l'une quelconque des revendications précédentes, **caractérisé en ce que** les cellules solaires (40) sont formées par des cellules solaires à semi-conducteur et les cellules solaires (40) comprennent respectivement une cellule solaire triple avec un composé du troisième groupe chimique principal et un composé du cinquième groupe chimique principal.
